# EUROPEAN PATENT APPLICATION

(11) **EP 1 533 863 A1**
(43) Date of publication of application: **25.05.2005**
(21) Application number: 04105903.1
(22) Date of filing: 18.11.2004
(51) Int. Cl.: H01Q 1/00, H01Q 9/00, H01Q 23/00, H03H 7/38

(54) **An Active Antenna**

(30) Priority: 19.11.2003 KR 2003082230
(71) Applicant: SAMSUNG ELECTRONICS CO., LTD., Suwon-City, Kyungki-do (KR)
(72) Inventor: BAE, Bum-youl, Daejeon (KR)
(74) Representative: Geary, Stuart Lloyd

(57) **Abstract**

An active antenna, the electrical length of which can be varied with the use of an inductor coil and which has an amplification circuit, is provided. The active antenna comprises a passive antenna module, which receives a signal within a predetermined frequency band and adjusts an electrical length thereof; and an amplification circuit, which amplifies a signal output from the passive antenna module at an antenna port and transmits the amplified signal to a digital broadcast receiver. The active antenna obtains a high signal-to-noise ratio by amplifying the signal at the antenna port in a digital broadcast receiver, which receives data-in-national television system committee (dNTSC).

## Description

The present invention relates to an antenna for receiving wireless signals, and more particularly, to an active antenna with an inherent amplifier, the electrical length of which can be adjusted by using inductor coils.

In North America, the National Television System Committee (NTSC) broadcast system has been adopted for analogue TV broadcasting, and the Advanced Television System Committee (ATSC) broadcast system has been adopted for digital TV broadcasting. A data-in-NTSC (dNTSC) video broadcast is transmitted in the VHF-H bands. dNTSC allows digital signals to be interleaved into the NTSC band. Outdoor or indoor antennas have been used as VHF-H band antennas which receive dNTSC broadcasts. Indoor, rather than outdoor, antennas are sometimes more convenient because it is easier to connect an indoor antenna to a digital set-top box (STB) (which is sometimes necessary to receive digital broadcasts), than to connect an outdoor antenna to the digital STB.

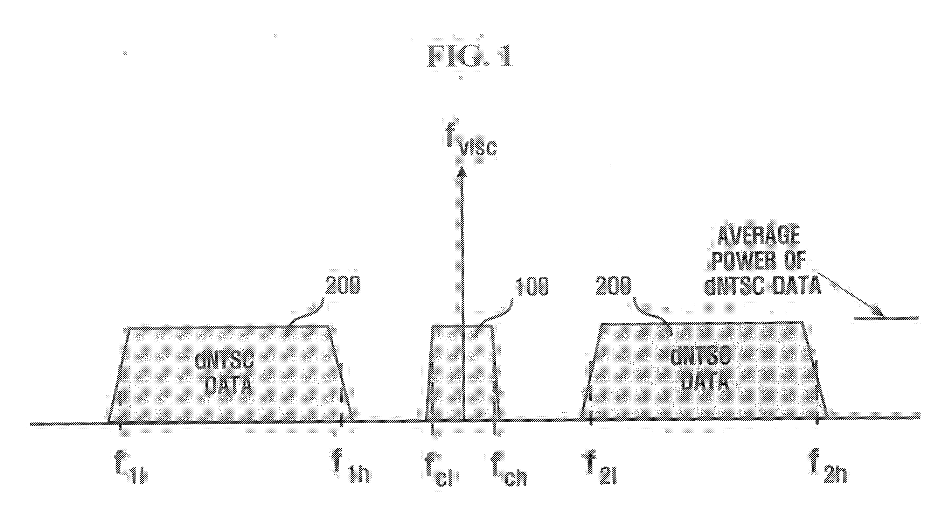

Figure 1 illustrates a frequency spectrum of the dNTSC system in a VHF-H band. An analogue broadcast signal 100 and a digital broadcast signal 200 are modulated using a double side band (DSB) modulation method. In the NTSC broadcast system, the analogue broadcast signal 100, whose frequency range is between f_{cl} and f_{ch}, is transmitted. A carrier is used during transmission, as would be appreciated. In the dNTSC broadcast system, the digital broadcast signal 200, i.e., a dNTSC data signal, which lies outside the frequency band of the analogue broadcast signal 100, is additionally transmitted with the analogue broadcast signal 100.

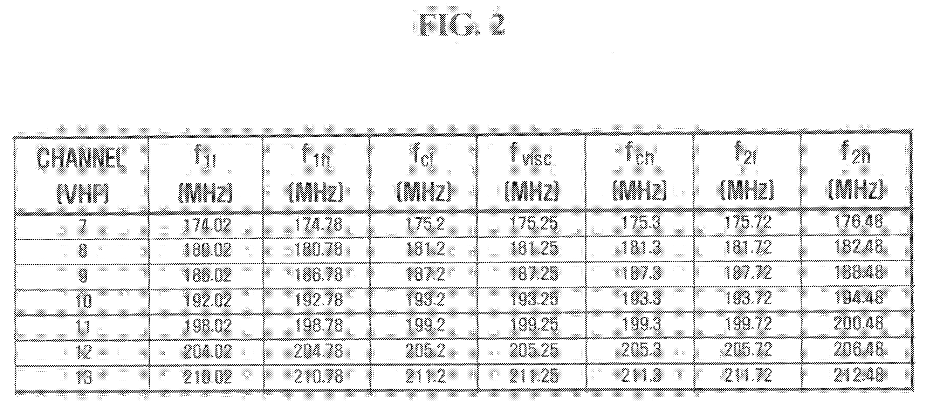

Figure 2 is a table showing frequencies of the various signals shown in Figure 1, when attributed to the different VHF channels 7 to 13. Referring to Figure 2, the carrier wave will lie somewhere in the frequency range from about 170 MHz to 220 MHz. Analogue broadcast signals in each of VHF channels 7 to 13 all have a frequency bandwidth of about 0.1 MHz. dNTSC data in each of VHF channels 7 to 13 all have a frequency bandwidth of about 0.76 MHz.

An indoor antenna is not suitable for receiving VHF-H band signals that include dNTSC data because of the size of them. In addition, due to the size restriction of the indoor antenna, it is very difficult to increase their size so as to be more suited for the desired frequency band. This is especially the case with a dipole antenna. The length of the dipole antenna should be about half the wavelength of the signal of most interest. For example, a dipole antenna should have a length of about 0.88 m to be appropriate for a signal of interest having a frequency of 170 MHz (300/170/2 = 0.88 m). However, an antenna of such size is unsuitable and inconvenient to use indoors. Thus, it is necessary to design an antenna which has the desired electrical length for the frequency of interest but also occupies a smaller space.

Signals within a VHF-H band are more likely to be affected by electrical noise than signals in a higher frequency band. Thus, it is necessary to amplify the signals in the VHF-H band in order to obtain a higher signal-to-noise ratio (SNR). Since signals amplified at the port of the antenna are more likely to have a higher signal-to-noise ratio than the signals amplified in other parts of the digital broadcast receiver, it is necessary to develop a receiver which actively amplifies signals at the antenna to obtain a higher SNR.

The present invention provides a VHF-H band antenna whose electrical length can be increased with the use of serial inductors.

The present invention also provides a digital receiving apparatus, which addresses the limitations of known passive antennas and can obtain a higher signal-to-noise ratio (SNR) for the received signal by amplifying signals at the antenna.

In accordance with an exemplary embodiment of the present invention, there is provided an active antenna comprising a passive antenna module, which receives a signal within a predetermined frequency band that is input spatially by adjusting an electrical length thereof, and an amplification circuit, which amplifies a signal output from the passive antenna module at an antenna port and transmits the amplified signal to a digital broadcast receiver.

The active antenna further comprises a bias-stabilizing module, which stabilizes a bias voltage applied from the digital broadcast receiver by removing components other than the bias component from the bias voltage.

The active antenna can also comprise a bias-blocking module, which blocks the bias current generated by the bias voltage applied from the digital broadcast receiver and allows the signal output from the signal-amplifying module pass through the same, and a signal-blocking module, which prevents the signal from being transmitted along a path of the bias current passing through the bias-stabilizing module.

The active antenna further comprises an electrostatic discharge (ESD) protecting module, which protects the bias voltage applied from the digital broadcast receiver against deleterious electrostatic discharges so that the bias voltage can be maintained at a predetermined level or lower.

The digital broadcast receiver preferably receives data-in-national television system committee (dNTSC) data transmitted in a VHF-H band.

The passive antenna module can comprise an inductor coil, which varies the electrical length of the passive antenna module to receive a predetermined signal, a first capacitor, which matches impedance thereof with that of the inductor coil for a predetermined frequency band, and a second capacitor, which serves as a tuning point for the predetermined frequency band.

The predetermined frequency band is preferably a VHF-H band.

The signal-amplifying module can comprise a transistor, which amplifies a signal input to a base thereof from the passive antennal module by a predetermined gain and outputs the amplified signal to a collector thereof, and at least one resistor, which controls the bias voltage of the transistor.

Also, the active antenna can further comprise a capacitor, which matches impedances of the signal output from the passive antenna module and input to the signal amplifying module.

The bias-stabilizing module can comprise a voltage regulator, which attenuates the noise component included in the bias voltage applied from the digital broadcast receiver, and at least one capacitor, which stabilizes the bias voltage applied thereto. The bias-blocking module may serve as a capacitor, which couples signals output from the signal-amplifying module.

The signal-blocking module preferably includes two inductors.

The electrostatic discharge (ESD) protecting module is preferably a Zener diode.

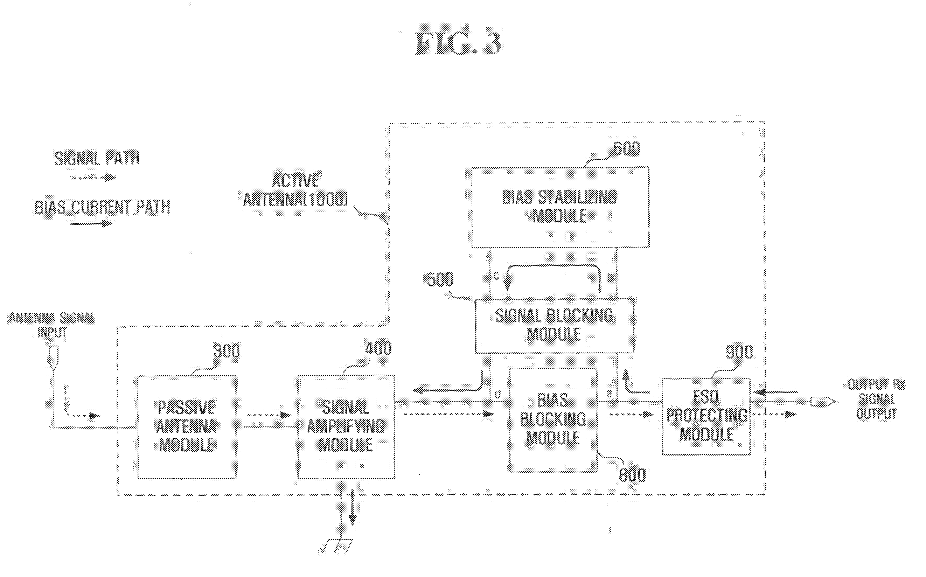

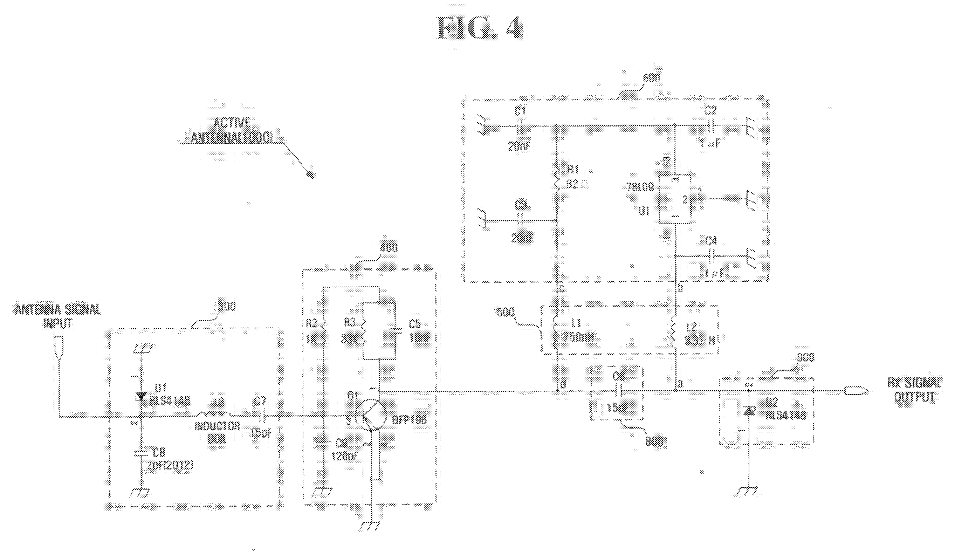

An embodiment of the present invention will now be described, by way of example only, and with reference to Figures 3 and 4 of the accompanying drawings, in which:
Figure 1 illustrates the frequency spectrum based of the dNTSC broadcast system in a VHF-H band;
Figure 2 is a table showing frequencies of various signals shown in Figure 1;
Figure 3 is a block diagram of an active antenna according to an embodiment of the present invention; and
Figure 4 is a schematic circuit diagram of an active antenna according to the embodiment of the present invention.

The present invention will now be described more fully with reference to the accompanying drawings, in which preferred embodiments of the invention are shown. This invention may, however, be embodied in many different forms and should not be construed as being limited to the embodiments set forth herein. In the drawings, the same reference numerals represent the same elements.

Referring to Figure 3, a bias current is supplied to the active antenna 1000. This bias current comes from a receiver (Rx) signal output unit, such as a digital broadcast receiver (which may be a set-top box). The bias current passes through an electrostatic discharge (ESD) module 900. The ESD protecting module 900 protects the active antenna 1000 against electrostatic discharges ensuring that the voltage at terminal with the broadcast receiver is maintained at, or below, a predetermined level. The ESD protecting module 900 also protects the digital broadcast receiver from electrostatic discharges from the antenna 1000.

After passing through the ESD protecting module 900, the bias current tries to pass through a bias-blocking module 800. The bias-blocking module 800 blocks the bias current so that the bias current flows to the signal blocking module 500, i.e. from path "a" to "b".

The bias current passing through the signal-blocking module 500 is fed to the bias-stabilizing module 600. The bias-stabilizing module 600 stabilizes the bias current by removing undesired components, such as ripples or noise, from the bias current. As will be explained hereinafter, a steady voltage is also generated at the output of the bias-stabilising module 600. The bias current output from the bias-stabilizing module 600 is fed to the signal-amplifying module 400 via the signal-blocking module 500. The signal-amplifying module 400 sends the bias current to ground.

An input signal path will now be described with reference to Figure 3. A received signal is input to the active antenna 1000 from a conventional passive antenna module 300. The signal passing through the passive antenna module 300 is fed to the signal-amplifying module 400. The signal-amplifying module 400 amplifies the signal to an appropriate level so that the amplified signal is appropriate for the set-top box. This may mean increasing the amplified signal strength so that a particular SNR is achieved. The amplified signal is fed to the signal blocking module 500 and the bias-blocking module 800. The signal-blocking module 500 prevents the amplified signal from being transmitted along the path of the bias current passing through the bias-stabilizing module 600, by impedance mismatching. However, the bias blocking module 800 allows the amplified AC signal to pass therethrough.

Therefore, the amplified signal passing through the bias-blocking module 800 is not transmitted along the path "d" to "c", but is transmitted through the bias-blocking module 800. After passing through the bias-blocking module 800, the amplified signal cannot be transmitted in the direction "b" to "a", due to the signal-blocking module 500. Instead, the amplified signal that passed through the bias-blocking module 800 is fed into the ESD protecting module 900. The amplified signal that has passed through the ESD protecting module 900 is fed into the set-top box as the Rx signal output.

Referring to Figure 4, the passive antenna module 300 is of a passive type, that is, the passive antenna module 300 is composed of substantially passive devices, and comprises a variable inductor coil L3, which can vary the electrical length of the passive antenna module 300 in a range between 12 cm and 22 cm. Therefore, the passive antenna module 300 can cover a frequency band from 170 MHz to 220 MHz, i.e., a VHF-H band. In order to increase the SNR in the VHF-H frequency band by impedance matching, a coupling capacitor C7 is coupled to the variable inductor coil L3. The passive antenna module 300 further includes a capacitor C8, which serves as a tuning point, and a Zener diode D1 which limits the maximum magnitude of the AC signal input to the active antenna 100. A commercially available diode model RLS4148 is preferably used as the Zener diode D1.

The AC signal received by the antenna is fed to the passive antenna module 300 and then fed to the signal-amplifying module 400 via the coupling capacitor C7. The signal-amplifying module 400 includes a transistor Q1, which amplifies the signal fed into the base of the transistor Q1. A voltage of 8 V is applied to the collector in the transistor Q1. A resistor R3 and parallel capacitor C5 are connected in series with a resistor R2 between the collector and the base of the transistor Q1. The resistors R2 and R3 control the bias voltage of the transistor Q1. The base voltage is determined by the resistor R2, the resistor R3, the capacitor C5, and properties of the transistor Q1. In the present embodiment, a voltage of 0.7 V is applied to the base of the transistor Q1 and serves as a threshold voltage. A capacitor C9 is used as impedance matching for the signal output from the passive antenna module 300 to the signal amplifying module 400.

A transistor BFP196LAN, manufactured by SimensAG (RTM), is used as the transistor Q1 in this embodiment. It is preferable to amplify the signal in the signal amplifying-module 400 located nearer to the passive antenna module 300 than in the set-top box. This is because the closer the received signal is to the input port of the active antenna 1000, the less noise/distortion the signal contains. A signal with less distortion is more likely to have a higher SNR after being amplified. The transistor Q1 is designed such that its gain is about 12 dB in the VHF-H band of interest. In this case, the current at the collector of the transistor Q1 is 50 mA.

With reference to Figure 4, the signal input to the base of the transistor Q1 is amplified by a predetermined gain and then output from the collector of the transistor Q1. Since the signal output from the collector of the transistor Q1 is an AC signal, it passes through the capacitor C6. The capacitor C6 serves as a coupling capacitor, for the amplified AC signals output from the transistor Q1.

The signal output from the collector of the transistor Q1 is stopped from travelling in the path "d" to "c" by an inductor L1. This is because of inductance mismatching. The AC signal passing through the capacitor C6 is stopped from travelling in a direction "a" to "b" by an inductor L2. Therefore, the AC signal passing through the capacitor C6 is fed into the set-top box as the Rx signal output.

Referring to Figure 4, a bias voltage of 12 V is applied to the Rx signal output port by the set-top box. The bias voltage applied to the Rx signal output port is limited to 12V using the Zener diode D2 to protect against any sudden electrostatic discharges. Like D1, the Zener diode, D2 is diode model No. RLS4148. Since the bias current passing through the Zener diode D2 is a DC current, it cannot pass through the capacitor C6 and thus flows toward the inductor L2. The bias current passing through the inductor L2 is fed to a voltage regulator U1. The voltage regulator U1 is voltage regulator model No. 78L09. The voltage regulator U1 reduces the noise present in the power supply voltage provided at the Rx signal output port of the set-top box. More specifically, the voltage regulator U1 stabilizes the bias voltage by removing components other than the DC component from the bias voltage. A bias voltage of 12 V is applied to the input port 1 of the voltage regulator U1, and a bias voltage of 9 V is generated at an output port 3 of the voltage regulator U1. The resistor R1 has 1V dropped across it, meaning that a bias voltage of 8 V is supplied to the collector of the transistor Q1. The bias-stabilizing module 600 comprises the voltage regulator U1 and four capacitors C1, C2, C3 and C4. Each of the four capacitors C1 to C4 act to remove noise from the DC signal by removing AC components of the DC bias voltage.

Accordingly, a bias voltage of 8 V is applied to the collector of the transistor Q1, and a voltage of 0.7 V is applied to the base of transistor Q1.

Therefore, the active antenna according to the present invention is better than a known passive antenna because the influence of the length of an antenna on the frequency range over which the antenna operates is reduced. Numerous test results show that the present invention reduces the variation of frequency response with respect to the length of an antenna by variably setting the electrical length of the passive antenna module 300. Therefore, the active antenna according to the present invention, may serve as a broadband antenna.

According to the present invention, an indoor antenna tuned to a VHF-H band can be used in a very small space.

In addition, it is possible to obtain a high signal-to-noise ratio by amplifying dNTSC data at the antenna port in a digital receiver.

Moreover, the active antenna according to the present invention can reduce the influence of the length of the antenna on the frequency band over which the antenna can effectively operate more than a known passive antenna. Therefore, the active antenna according to the present invention can be used as a broadband antenna.

## Claims

1. An active antenna comprising:
a passive antenna module, which receives a signal within a predetermined frequency band and adjust an electrical length thereof; and
a signal-amplifying module, which amplifies a signal output from the passive antenna module at an antenna port and transmits the amplified signal to a digital broadcast receiver.

2. The active antenna of claim 1, further comprising a bias-stabilizing module, which stabilizes a bias voltage supplied from the digital broadcast receiver by removing components other than the bias component from the bias voltage.

3. The active antenna of claim 2, further comprising:
a bias-blocking module, which blocks the bias current generated by the bias voltage supplied from the digital broadcast receiver and allows the signal output from the signal-amplifying module pass through the same; and
a signal-blocking module, which prevents the signal from being transmitted along a path of the bias current passing through the bias-stabilizing module.

4. The active antenna of claim 3, further comprising an electrostatic discharge (ESD) protecting module, which protects the bias voltage supplied from the digital broadcast receiver against electrostatic discharges so that the bias voltage can be maintained at a predetermined level or lower.

5. The active antenna of claim 1, wherein the digital broadcast receiver receives data-in-National Television System Committee (dNTSC) data transmitted in a VHF-H band.

6. The active antenna of claim 1, wherein the passive antenna module comprises:
an inductor coil, which varies the electrical length of the passive antenna module to receive a predetermined signal;
a first capacitor, which matches impedance thereof with that of the inductor coil for a predetermined frequency band; and
a second capacitor, which serves as a tuning point for the predetermined frequency band.

7. The active antenna of claim 6, wherein the predetermined frequency band is a VHF-H band.

8. The active antenna of claim 1, wherein the signal-amplifying module comprises:
a transistor, which amplifies a signal input to a base thereof from the passive antennal module by a predetermined gain and outputs the amplified signal to a collector thereof; and
at least one resistor, which controls the bias voltage of the transistor.

9. The active antenna of claim 8, further comprising a capacitor for matching input impedances of signals that are output from the passive antenna module and input to the signal-amplifying module.

10. The active antenna of claim 2, wherein the bias-stabilizing module comprises:
a voltage regulator, which attenuates the noise component included in the bias voltage supplied from the digital broadcast receiver; and
at least one capacitor, which stabilizes the bias voltage applied thereto.

11. The active antenna of claim 3, wherein the bias-blocking module serves as a capacitor, which couples signals output from the signal-amplifying module.

12. The active antenna of claim 3, wherein the signal-blocking module comprises two inductors.

13. The active antenna of claim 4, wherein the electrostatic discharge (ESD) protecting module is a Zener diode.

14. A method of operating an active antenna comprising the steps of:
receiving a signal within a predetermined frequency band and adjusting an electrical length thereof via a passive antenna; and
amplifying the signal and transmitting the amplified signal to a digital broadcast receiver, the signal being amplified more proximally to the passive antenna than to the digital broadcast receiver.

15. A method as claimed in claim 14, further comprising the step of:
stabilizing a bias voltage supplied from the digital broadcast receiver by removing components other than the bias component from the bias voltage.

16. A method as claimed in claim 15, further comprising the steps of:
blocking the bias current generated by the bias voltage supplied from the digital broadcast receiver while passing the amplified signal; and
preventing the signal from being transmitted along the path of the bias current.

17. A method as claimed in claim 16, further comprising the step of protecting the bias voltage supplied from the digital broadcast receiver against electrostatic discharges so that the bias voltage can be maintained at a predetermined level or lower.

18. A method as claimed in claim 14, wherein the receiving step further comprises the steps of:
varying the electrical length of a passive antenna to receive a predetermined signal; and
matching the impedance of a capacitor with that of an inductor coil for a predetermined frequency band.

19. A method as claimed in claim 17, wherein the predetermined frequency band is a VHF-H band.

20. A method as claimed in claim 15, wherein the stabilizing step comprises the step of:
attenuating the noise component included in the bias voltage supplied from the digital broadcast receiver.
